# EUROPEAN PATENT APPLICATION

(11) **EP 4 838 235 A2**
(43) Date of publication of application: **11.11.2026**
(21) Application number: 26201621.5
(22) Date of filing: 28.08.2026
(51) Int. Cl.: G01R 31/3187, G06F 11/27

(54) **CHIP SELF-TEST METHOD AND APPARATUS, STORAGE MEDIUM, AND ELECTRONIC DEVICE**

(30) Priority: 03.08.2026 SG 10202602683R
(71) Applicant: XG TECH PTE. LTD., Singapore 179098 (SG)
(72) Inventor: LIN, Wei, 179098 Singapore (SG); WU, Liang, 179098 Singapore (SG)
(74) Representative: v. Bezold & Partner Patentanwälte - PartG mbB

(57) **Abstract**

The present disclosure relates to the technical field of chips, and provides a chip self-test method and apparatus, a storage medium, and an electronic device. The method is applied to an integrated circuit including a first processor. The method includes: writing self-test information from a non-volatile memory into a tightly-coupled memory; writing the self-test information from the tightly-coupled memory into a register of a self-test control unit; and in response to the register of the self-test control unit being updated with the self-test information, sending, by the self-test control unit, a first test instruction to the first processor to be self-tested, so as to trigger, based on the first test instruction, the first processor to enter a self-test mode.

## Description

### TECHNICAL FIELD

The present disclosure relates to the technical field of chips, and in particular, to a chip self-test method and apparatus, a storage medium, and an electronic device.

### BACKGROUND

In a chip design process, design for testability (DFT) is a method that embeds test structures and mechanisms during a chip design phase. This method can improve a test effect after chip manufacturing. The DFT typically implements chip self-test based on a test vector.

In a test scenario where a DFT test vector is not hard-coded in hardware, the test vector may be dynamically loaded by software or firmware for use in chip self-test. However, a process of dynamically loading the test vector currently has problems of a slow loading speed, high memory occupation, and impact on device startup.

### SUMMARY

To resolve the foregoing technical problems, the present disclosure provides a chip self-test method and apparatus, a storage medium, and an electronic device. Dynamic loading of self-test information is implemented based on a tightly-coupled memory in a chip, thereby increasing a chip self-test speed and ensuring fast startup of the electronic device.

According to a first aspect of the present disclosure, a chip self-test method is provided. The method is applied to an integrated circuit including a first processor. The method includes: writing self-test information from a non-volatile memory into a tightly-coupled memory; writing the self-test information from the tightly-coupled memory into a register of a self-test control unit; and in response to the register of the self-test control unit being updated with the self-test information, sending, by the self-test control unit, a first test instruction to the first processor to be self-tested, so as to trigger, based on the first test instruction, the first processor to enter a self-test mode.

According to a second aspect of the present disclosure, a chip self-test apparatus is provided. The apparatus is applied to an integrated circuit including a first processor. The apparatus includes: a first writing module, configured to write self-test information from a non-volatile memory into a tightly-coupled memory; a second writing module, configured to write the self-test information from the tightly-coupled memory into a register of a self-test control unit; and a first sending module, configured to, in response to the register of the self-test control unit being updated with the self-test information, send, by the self-test control unit, a first test instruction to the first processor to be self-tested, so as to trigger, based on the first test instruction, the first processor to enter a self-test mode.

According to a third aspect of the present disclosure, a computer program product is provided. When instructions in the computer program product are executed by a processor, the chip self-test method according to embodiments in the first aspect of the present disclosure is implemented.

According to a fourth aspect of the present disclosure, an electronic device is provided. The electronic device includes:
a processor; and a memory, configured to store instructions executable by the processor, wherein the processor is configured to read the executable instructions from the memory, and execute the instructions to implement the chip self-test method according to embodiments in the first aspect of the present disclosure.

According to a fifth aspect of the present disclosure, a computer readable storage medium is provided. The storage medium stores a computer program, and the computer program is used for implementing the chip self-test method according to embodiments in the first aspect of the present disclosure.

According to the chip self-test method and apparatus, the storage medium, and the electronic device that are provided in the foregoing embodiments of the present disclosure, the self-test information is written from the non-volatile memory into the tightly-coupled memory, and is written from the tightly-coupled memory into the register of the self-test control unit; and in response to the register of the self-test control unit being updated with the self-test information, the first test instruction is sent by the self-test control unit to the first processor to be self-tested, so as to trigger, based on the first test instruction, the first processor to enter the self-test mode. In this way, the electronic device implements the dynamic loading of the self-test information based on the tightly-coupled memory in the chip, thereby increasing the chip self-test speed and ensuring the fast startup of the electronic device.

### BRIEF DESCRIPTION OF THE DRAWINGS

FIG. 1 is an architecture diagram of a chip self-test system according to an exemplary embodiment of the present disclosure;
FIG. 2 is a schematic flowchart of a chip self-test method according to an exemplary embodiment of the present disclosure;
FIG. 3 is a flowchart of step S100 according to an exemplary embodiment of the present disclosure;
FIG. 4 is a flowchart of step S110 according to an exemplary embodiment of the present disclosure;
FIG. 5 is another schematic flowchart of a chip self-test method according to an exemplary embodiment of the present disclosure;
FIG. 6 is a flowchart of step S600 according to an exemplary embodiment of the present disclosure;
FIG. 7 is still another schematic flowchart of a chip self-test method according to an exemplary embodiment of the present disclosure;
FIG. 8 is yet another schematic flowchart of a chip self-test method according to an exemplary embodiment of the present disclosure;
FIG. 9 is a schematic diagram of a structure of a chip self-test apparatus according to an exemplary embodiment of the present disclosure; and
FIG. 10 is a diagram of a structure of an electronic device according to an embodiment of the present disclosure.

### DETAILED DESCRIPTION OF THE EMBODIMENTS

To explain the present disclosure, exemplary embodiments of the present disclosure are described below in detail with reference to accompanying drawings. Obviously, the embodiments described are merely some, rather than all of embodiments of the present disclosure. It should be understood that the present disclosure is not limited by the exemplary embodiments.

It should be noted that, unless otherwise specifically stated, the relative arrangement of components and steps, numerical expressions, and numerical values set forth in these embodiments do not limit the scope of the present disclosure.

### Application overview

In a cockpit-driving integrated system on a chip (SOC), there are numerous gate circuits, which cause a volume of DFT test data to grow super-linearly. In this case, in a DFT process, if a self-test vector is hard-coded in hardware, there may be risks (such as risks of area overhead and routing congestion) caused by an explosion in the volume of the test data. Therefore, DFT may load the self-test vector based on software. However, the process of loading the test vector based on the software has problems of a slow loading speed, high memory occupation, and impact on device startup.

To resolve the foregoing technical problems, the present disclosure provides a chip self-test method and apparatus, a storage medium, and an electronic device. The method includes: writing self-test information from a non-volatile memory into a tightly-coupled memory; writing the self-test information from the tightly-coupled memory into a register of a self-test control unit; and in response to the register of the self-test control unit being updated with the self-test information, sending, by the self-test control unit, a first test instruction to a first processor to be self-tested, so as to trigger, based on the first test instruction, the first processor to enter a self-test mode. In this way, the electronic device implements dynamic loading of the self-test information based on the tightly-coupled memory in the chip, thereby increasing a chip self-test speed and ensuring fast startup of the electronic device.

### Exemplary system

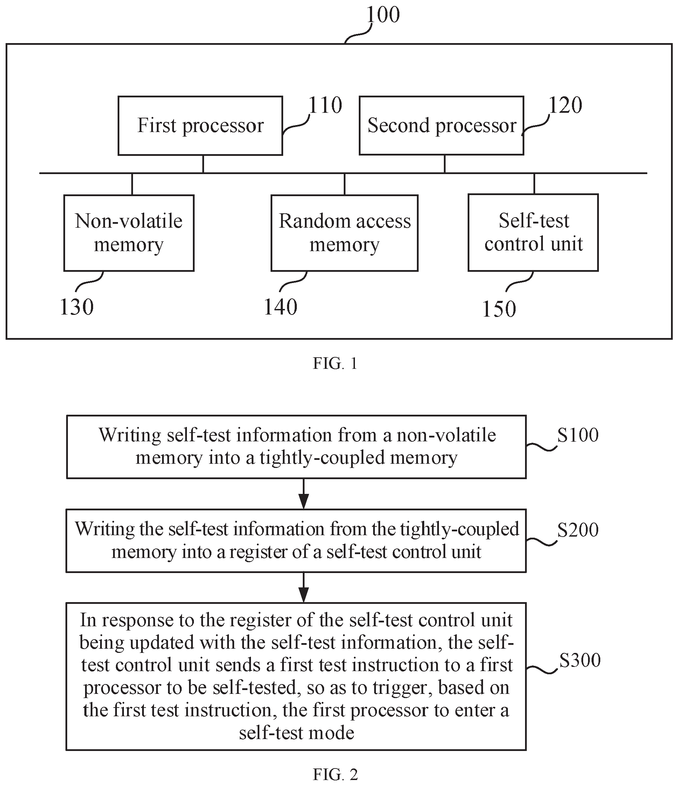

FIG. 1 is an architecture diagram of a chip self-test system according to an exemplary embodiment of the present disclosure.

As shown in FIG. 1, in some embodiments, a chip self-test system 100 according to this embodiment of the present disclosure includes a first processor 110, a second processor 120, a non-volatile memory 130, a random access memory 140, and a self-test control unit 150 that are deployed on the same chip.

In some embodiments, the non-volatile memory 130 includes a read-only memory (ROM), an erasable programmable read-only memory (EPROM), an electrically erasable programmable read-only memory (EEPROM), a flash memory, and the like.

In the embodiments of the present disclosure, the non-volatile memory 130 is, for example, a flash memory. The flash memory has characteristics of erasing in units of "blocks", a fast write speed, high integration, and low cost.

The flash memory may be configured to store self-test information.

The self-test information includes a self-test vector. The self-test vector is a set of predefined input stimulus sequence values and corresponding expected output response values of an integrated circuit that are used to verify, during a self-test process, whether a circuit function is normal.

The input stimulus sequence values refer to a set of specific data or signal combinations applied to an input terminal of the tested circuit. The expected output response values refer to correct output results that the circuit needs to produce during normal operation under given inputs. The chip self-test system 100 may compare an actual output result of the circuit with the expected output response value, determine that self-test succeeds when the actual output result is consistent with the expected output response value, and determine that the self-test fails when the actual output result is inconsistent with the expected output response value. In this way, the chip self-test system 100 may detect problems such as bridging short circuits and delay faults based on the self-test information, and may also verify whether the circuit can correctly perform basic operations such as read/write, computation, and state switching.

The second processor 120 may be a security co-processor, being configured to handle security-critical operations including key management, identity authentication, and encryption/decryption of sensitive data in a trusted execution environment.

The second processor 120 may be configured to perform the following operation:
writing the self-test information from the non-volatile memory into the random access memory 140.

In this way, the self-test information is not hard-coded in firmware, ensuring that the second processor 120 can flexibly load the self-test information into the random access memory 140.

The random access memory 140 is configured to store program instructions executable by a processor (such as the first processor 110 or the second processor 120), or to store data (such as the self-test information).

In some embodiments, the random access memory 140 includes a static random access memory (SRAM), a dynamic random access memory (DRAM), a synchronous dynamic random access memory (SDRAM), and the like.

The SRAM includes a tightly-coupled memory (TCM), which has characteristics of low latency, high determinism, and direct software controllability. The tightly-coupled memory includes a data tightly-coupled memory (DTCM) and an instruction tightly-coupled memory (ITCM). The data tightly-coupled memory is configured to store real-time data, sensitive variables, or test vectors for data access by the processor. The instruction tightly-coupled memory is configured to store critical code (such as an interrupt service routine and secure boot code).

The second processor 120 may be configured to perform the following operation:
writing the self-test information from the non-volatile memory into the data tightly-coupled memory.

In this way, the second processor 120, while flexibly loading the self-test information into the random access memory 140, may also implement functions such as temporary data acceleration, releasing after use, and low-power pre-loading based on the data tightly-coupled memory. These functions are specifically described in the following embodiments of the present disclosure, and details are not described herein.

The self-test control unit 150 is a hardware module configured to carry the self-test function within a chip.

The second processor 120 is further configured to perform the following operation:
writing the self-test information from the random access memory 140 into a register of the self-test control unit 150.

The first processor 110 may be a main system processor, being configured to handle user-level application programs and system scheduling.

In some embodiments, the first processor 110 may include one or more processing units, for example, may include an application processor (AP), a modem processor, a graphics processing unit (GPU), an image signal processor (ISP), a controller, a video codec, a digital signal processor (DSP), a baseband processor, and/or a neural-network processing unit (NPU). Different processing units may be independent devices, or may be integrated in one or more processors.

The self-test control unit 150 may be configured to perform the following operation:
based on a value of the register being updated with the self-test information, sending a first test instruction to the first processor 110, so as to trigger, based on the first test instruction, the first processor 110 to enter a self-test mode.

According to the chip self-test system 100 shown in the embodiments of the present disclosure, the self-test information is written from the non-volatile memory into the random access memory 140, and is written from the random access memory 140 into the register of the self-test control unit; and in response to the register of the self-test control unit being updated with the self-test information, the first test instruction is sent by the self-test control unit to the first processor to be self-tested, so as to trigger, based on the first test instruction, the first processor to enter the self-test mode. In this way, the electronic device implements dynamic loading of the self-test information based on the random access memory 140 in the chip, thereby increasing a chip self-test speed and ensuring fast startup of the electronic device.

### Exemplary method

FIG. 2 is a schematic flowchart of a chip self-test method according to an exemplary embodiment of the present disclosure. This embodiment may be applied to an electronic device. As shown in FIG. 2, the chip self-test method may specifically be applied to an integrated circuit of the electronic device, where the integrated circuit includes a first processor. The method includes the following steps.

Step S100: Writing self-test information from a non-volatile memory into a tightly-coupled memory.

In some embodiments, the integrated circuit further includes a second processor.

The electronic device may perform steps S100 to S400 based on a dual-processor architecture (that is, an architecture in which the first processor and the second processor work together) of the integrated circuit.

The second processor may further be configured to carry a boot loading function and a security monitoring function of an SOC.

In some embodiments, the second processor writes the self-test information from the non-volatile memory into the tightly-coupled memory.

With the implementation of this step, although the non-volatile memory can store the self-test information for a long time, a read speed thereof is far lower than that of an on-chip static random access memory. Therefore, by writing the self-test information from the non-volatile memory into the tightly-coupled memory, the second processor can read the data in the tightly-coupled memory at a high speed, so as to avoid a problem of long self-test time caused by the second processor frequently accessing a slow external memory, which significantly reduces loading time for instructions and data, thereby accelerating an overall self-test rate of the electronic device.

Step S200: Writing the self-test information from the tightly-coupled memory into a register of a self-test control unit.

In some embodiments, the second processor writes the self-test information from the tightly-coupled memory into the register of the self-test control unit.

The self-test control unit is a hardware control module in the SOC that is responsible for an entire chip self-test process, to uniformly manage self-test startup, test vector loading, test execution, mode switching, result determining, and resource release.

The second processor may write the self-test information from the tightly-coupled memory into a dedicated register for storing a test vector in the self-test control unit.

In this way, the self-test control unit may implement hardware-level autonomous triggering without intervention from the second processor, thereby improving a self-test response speed.

With the implementation of this step, the self-test control unit may independently start and complete an entire test process (such as generating stimuli, driving a to-be-tested module, capturing responses, and comparing results) based on register configuration, without real-time participation of the second processor. Thus, burden on the second processor is significantly reduced. In this way, the second processor may also be used for other system initialization or application tasks, thereby improving overall system efficiency.

Step S300: In response to the register of the self-test control unit being updated with the self-test information, the self-test control unit sends a first test instruction to the first processor to be self-tested, so as to trigger, based on the first test instruction, the first processor to enter a self-test mode.

In some embodiments, the self-test control unit sends, in response to the register being updated with the self-test information, the first test instruction to the first processor to be self-tested, so as to trigger, based on the first test instruction, the first processor to enter the self-test mode.

With the implementation of this step, the electronic device sends the first test instruction based on the self-test control unit, rather than through a general-purpose software-accessible interrupt controller or register, thereby ensuring security and isolation of the self-test.

According to the technical solutions shown in the present disclosure, the self-test information is written from the non-volatile memory into the tightly-coupled memory, and is written from the tightly-coupled memory into the register of the self-test control unit; and in response to the register of the self-test control unit being updated with the self-test information, the first test instruction is sent by the self-test control unit to the first processor to be self-tested, so as to trigger, based on the first test instruction, the first processor to enter the self-test mode. In this way, the electronic device implements dynamic loading of the self-test information based on the tightly-coupled memory in the chip, thereby increasing a chip self-test speed and ensuring fast startup of the electronic device.

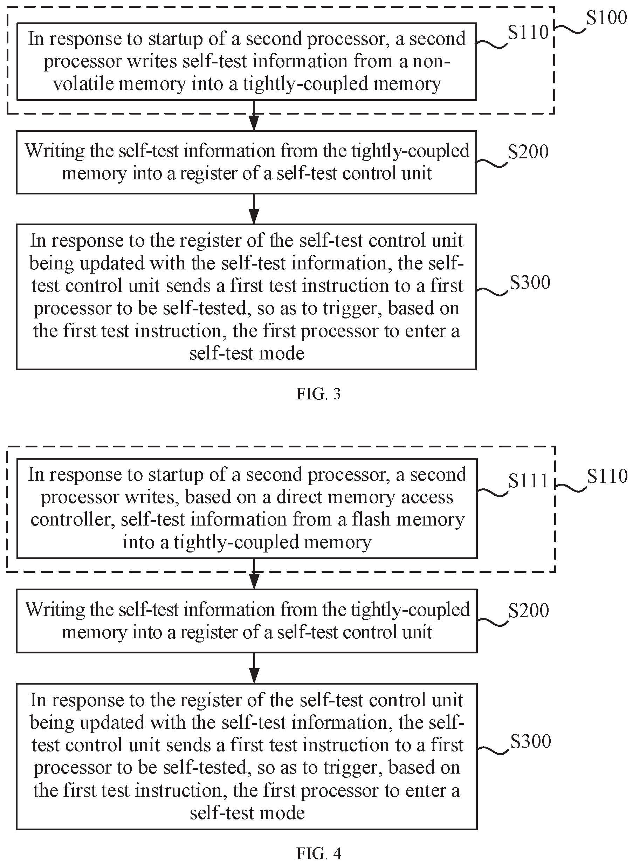

FIG. 3 is a flowchart of step S100 according to an exemplary embodiment of the present disclosure.

As shown in FIG. 3, step S100 of writing self-test information from a non-volatile memory into a tightly-coupled memory includes the following step.

Step S110: In response to startup of the second processor, the second processor writes the self-test information from the non-volatile memory into the tightly-coupled memory.

The second processor actively runs a loading task for the self-test information during startup, so that the first processor can execute other initialization tasks at the same time, thereby significantly reducing preparation time from power-on of the electronic device to start of the self-test.

With the implementation of this step, the electronic device implements parallel loading of self-test tasks, which reduces overall initialization time and relieves burden on the first processor, thereby improving startup efficiency of the electronic device.

FIG. 4 is a flowchart of step S110 according to an exemplary embodiment of the present disclosure.

As shown in FIG. 4, the non-volatile memory includes a flash memory. Step S110 of in response to startup of the second processor, the second processor writes the self-test information from the non-volatile memory into the tightly-coupled memory includes the following step.

Step S111: In response to the startup of the second processor, the second processor writes, based on a direct memory access controller, the self-test information from the flash memory into the tightly-coupled memory.

The direct memory access (DMA) controller is a dedicated hardware module configured to implement high-speed data transmission between a peripheral and a memory (or between memories), bypassing a central processing unit.

In some embodiments, the second processor may first initialize the direct memory access controller. Specifically, the second processor may configure a source address, a destination address, a transmission length, a transmission direction, a trigger condition, and other parameters of the direct memory access controller, and start a direct memory access channel. Further, the direct memory access controller may take over a transmission process. Specifically, when having data ready, a peripheral (such as the flash memory) may send a request to the direct memory access controller, so that the direct memory access controller may control a bus based on the request, so as to write a data block from the flash memory into the tightly-coupled memory. Further, after the data transmission is completed, the direct memory access controller may generate an interrupt signal to notify the second processor that the current transmission process has ended, so that the second processor performs subsequent processing. During the entire process, the second processor may execute other tasks (such as computation, scheduling, and handling other interrupts), and only configures data controlled by the direct memory access controller at the start and end.

With the implementation of this step, the second processor performs data migration based on the direct memory access controller, thereby improving system throughput of the electronic device, preventing the second processor from executing inefficient data transfer loops, and reducing load on the second processor.

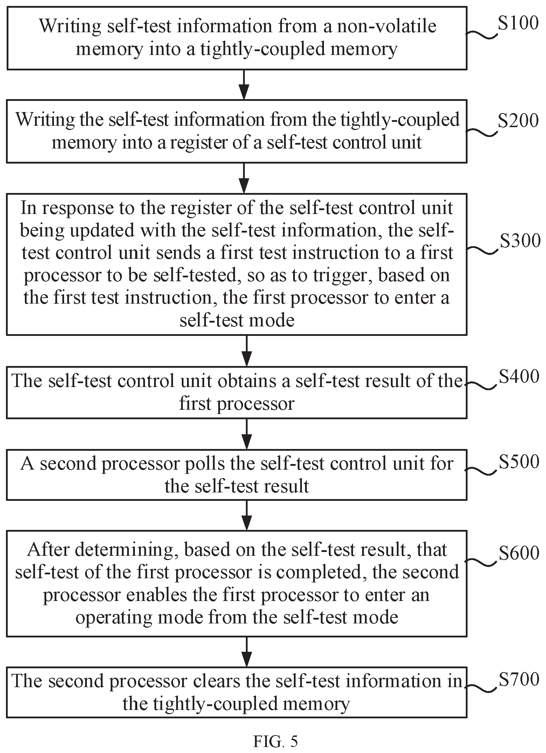

FIG. 5 is another schematic flowchart of a chip self-test method according to an exemplary embodiment of the present disclosure.

As shown in FIG. 5, after step S300 of in response to the register of the self-test control unit being updated with the self-test information, the self-test control unit sends a first test instruction to the first processor to be self-tested, so as to trigger, based on the first test instruction, the first processor to enter a self-test mode, the method further includes the following steps.

Step S400: The self-test control unit obtains a self-test result of the first processor.

In some embodiments, after the self-test is completed, the first processor may actively report a self-test result to the self-test control unit, or expose the self-test result to the self-test control unit, so that the self-test control unit directly obtains the self-test result.

With the implementation of this step, the electronic device obtains a result based on the self-test control unit, without occupying processor resources of the first processor or the second processor or requiring scheduling of an operating system. In this way, requirements of high real-time performance can be met.

Step S500: The second processor polls the self-test control unit for the self-test result.

Polling the self-test control unit for the self-test result by the second processor may trigger a subsequent mode switching operation.

With the implementation of this step, the electronic device polls the self-test control unit for the self-test result based on the second processor, which can enhance system observability and maintainability, and facilitate subsequent mode switching.

Step S600: After determining, based on the self-test result, that self-test of the first processor is completed, the second processor enables the first processor to enter an operating mode from the self-test mode.

The second processor ensures that the first processor switches from the self-test mode to the operating mode only when the self-test succeeds, thereby preventing a faulty processor from entering the operating mode to participate in a critical task. Moreover, the second processor reduces autonomous decision-making burden of the first processor, and reduces system complexity of the first processor.

With the implementation of this step, the second processor ensures security of the first processor during execution of a function of the first processor, which reduces load on the first processor and ensures orderliness of system startup.

Step S700: The second processor clears the self-test information in the tightly-coupled memory.

The tightly-coupled memory is a low-latency, high-bandwidth, area-expensive on-chip static random access memory. Data such as the self-test information used during the self-test phase and a temporary self-test result becomes useless after the first processor completes the self-test. By clearing the self-test information in the tightly-coupled memory, the second processor may release valuable storage resources of the tightly-coupled memory for data use in a next phase (for example, loading an operating system image).

With the implementation of this step, the second processor may avoid memory conflicts and leakage of sensitive data by clearing the self-test information in the tightly-coupled memory in a timely manner, thereby improving system security of the electronic device.

According to the technical solutions shown in the present disclosure, through phased utilization of the tightly-coupled memory, the electronic device not only ensures flexible and dynamic loading of a self-test vector, but also improves a self-test speed, thereby ensuring fast chip startup. Moreover, after exiting a DFT test mode, the electronic device also clears the resources in the tightly-coupled memory based on the second processor, so as to implement zero resource occupation of the tightly-coupled memory during operation of the first processor, thereby ensuring operating performance of the first processor and overall operating performance of the SOC.

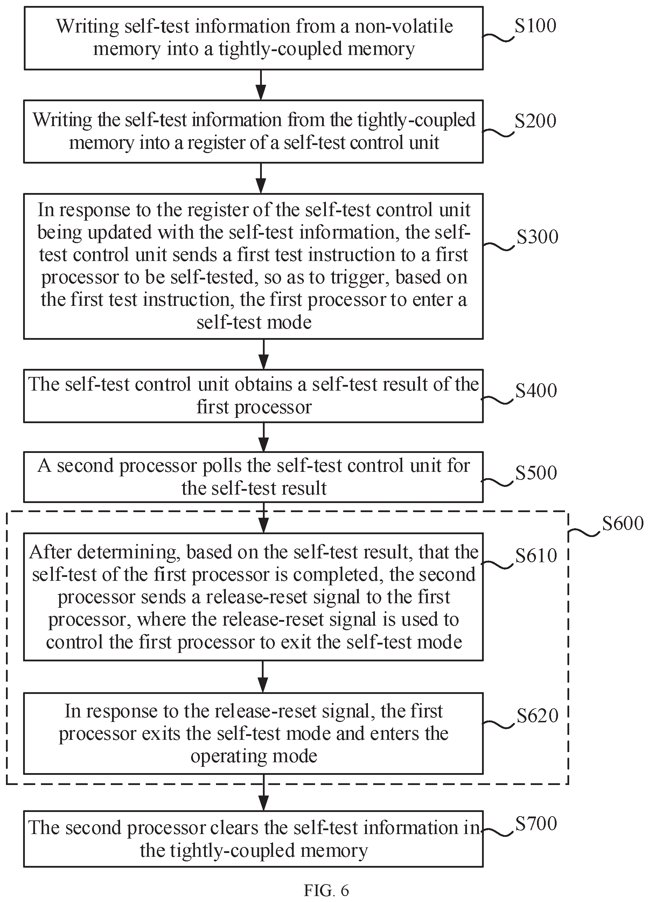

FIG. 6 is a flowchart of step S600 according to an exemplary embodiment of the present disclosure.

As shown in FIG. 6, after step S600 of after determining, based on the self-test result, that self-test of the first processor is completed, the second processor enables the first processor to enter an operating mode from the self-test mode, the method further includes the following steps.

Step S610: After determining, based on the self-test result, that the self-test of the first processor is completed, the second processor sends a release-reset signal to the first processor, where the release-reset signal is used to control the first processor to exit the self-test mode.

The release-reset signal is a hardware-level control signal with deterministic timing, extremely low latency, and high priority.

The second processor controls, based on the release-reset signal, the first processor to exit the self-test mode, which can enhance startup security and a fault isolation capability of the first processor.

With the implementation of this step, the second processor achieves precise and low-latency state control for the first processor based on a mechanism of sending the release-reset signal to the first processor, thereby improving self-test efficiency.

Step S620: In response to the release-reset signal, the first processor exits the self-test mode and enters the operating mode.

The first processor implements switching between the self-test mode and the operating mode based on the release-reset signal, which avoids a problem that when an unrecoverable error (such as lockup) occurs during the self-test process, the first processor cannot reliably exit merely based on software instructions.

With the implementation of this step, the first processor implements mode switching based on the hardware-level release-reset signal, thereby improving fault tolerance capability.

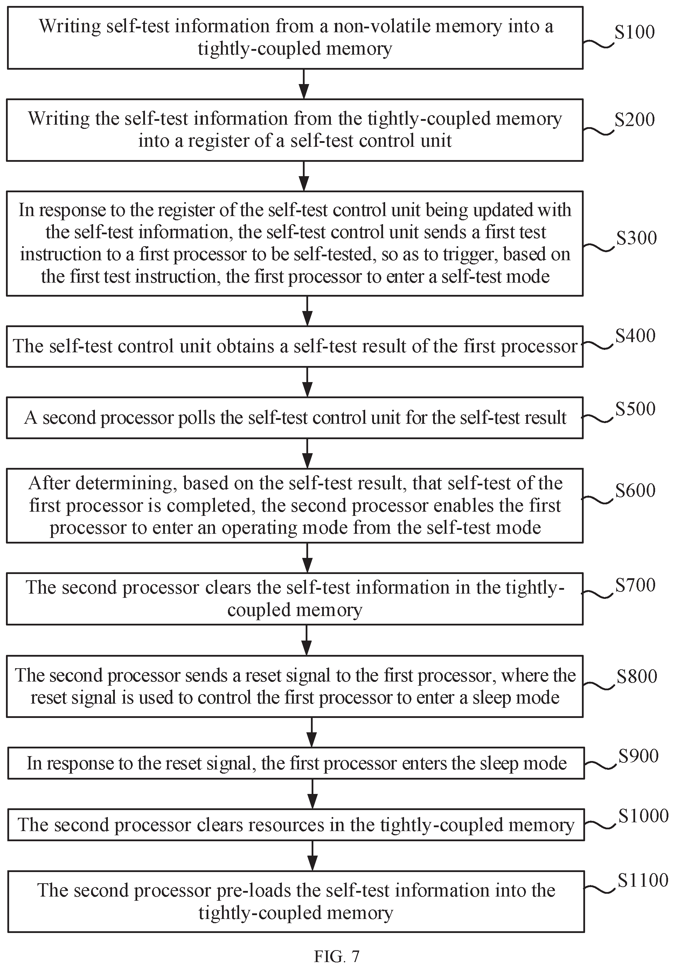

FIG. 7 is still another schematic flowchart of a chip self-test method according to an exemplary embodiment of the present disclosure.

As shown in FIG. 7, after step S700 that the second processor clears the self-test information in the tightly-coupled memory, the method further includes the following steps.

Step S800: The second processor sends a reset signal to the first processor, where the reset signal is used to control the first processor to enter a sleep mode.

In some embodiments, the second processor may actively send the reset signal to the first processor according to system load, diagnostic requirements, or a security policy. In this way, unified control for a power consumption state of a global processor is implemented by a trusted entity (that is, the second processor), thereby improving system reliability of the electronic device.

With the implementation of this step, the second processor actively controls, based on the reset signal, the first processor to enter the sleep mode, which can avoid a risk of losing control caused by the first processor autonomously making decisions.

Step S900: In response to the reset signal, the first processor enters the sleep mode.

The first processor implements switching between the operating mode and the sleep mode based on the reset signal, which avoids a problem that when an unrecoverable error (such as lockup) occurs during operation, the first processor cannot reliably exit merely based on software instructions.

With the implementation of this step, the first processor implements mode switching based on the reset signal and enters a low-power mode, which can reduce system power consumption of the electronic device.

Step S1000: The second processor clears resources in the tightly-coupled memory.

The second processor clears current resources in the tightly-coupled memory for subsequent storage of the self-test information, so that the first processor can quickly perform self-test based on the self-test information when exiting the low-power mode, thereby improving a self-test rate.

With the implementation of this step, the second processor may avoid memory conflicts and leakage of sensitive data by clearing the resources in the tightly-coupled memory in a timely manner. Moreover, this process may serve as a basis for performing self-test on the first processor again in the future.

Step S1100: The second processor pre-loads the self-test information into the tightly-coupled memory.

In some embodiments, the second processor pre-loads the self-test information from the flash memory into the tightly-coupled memory based on the direct memory access controller.

With the implementation of this step, the electronic device pre-loads the self-test information into the tightly-coupled memory in a low-power scenario such as the sleep mode, which improves a startup speed of the first processor when the first processor is woken up next time, thereby ensuring that the first processor achieves a characteristic of fast startup, and improving a functional safety specification of the chip.

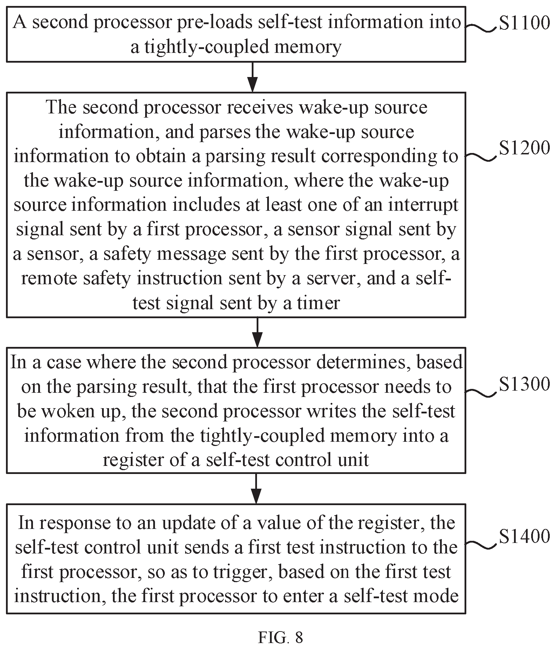

FIG. 8 is yet another schematic flowchart of a chip self-test method according to an exemplary embodiment of the present disclosure.

As shown in FIG. 8, after step S1100 that the second processor pre-loads the self-test information into the tightly-coupled memory, the method further includes the following steps.

Step S1200: The second processor receives wake-up source information, and parses the wake-up source information to obtain a parsing result corresponding to the wake-up source information, wherein the wake-up source information includes at least one of an interrupt signal sent by the first processor, a sensor signal sent by a sensor, a safety message sent by the first processor, a remote safety instruction sent by a server, and a self-test signal sent by a timer.

The electronic device receives the wake-up source information based on the second processor in the dual-processor architecture, rather than based on the first processor, so that the first processor does not need to parse the wake-up source information. In this case, parsing duration is reduced, so that fast startup requirements of the chip for self-test in a warm reset scenario and a sleep wake-up scenario can be met.

With the implementation of this step, the electronic device receives and parses the wake-up source information based on the second processor in the dual-processor architecture, which reduces startup time of the first processor, so that the first processor can perform self-test in the warm reset scenario and the sleep wake-up scenario, thereby improving the system security of the electronic device.

Step S1300: In a case where the second processor determines, based on the parsing result, that the first processor needs to be woken up, the second processor writes the self-test information from the tightly-coupled memory into the register of the self-test control unit.

The second processor configures the register of the self-test control unit when determining that the first processor needs to be woken up, thereby avoiding wastes of the resources in the tightly-coupled memory.

With the implementation of this step, the electronic device implements on-demand loading and precise configuration of the self-test information based on the second processor, to prepare for subsequent fast startup of the first processor, thereby improving overall chip self-test efficiency.

Step S1400: In response to an update of a value of the register, the self-test control unit sends the first test instruction to the first processor, so as to trigger, based on the first test instruction, the first processor to enter the self-test mode.

The self-test control unit immediately sends the first test instruction after the value of the register of the self-test control unit is updated. This process has low response latency, ensuring that the first processor can quickly enter the self-test mode.

With the implementation of this step, the electronic device sends the first test instruction based on the self-test control unit, rather than through a general-purpose software-accessible interrupt controller or register, thereby ensuring security and isolation of the self-test.

According to the technical solutions shown in the present disclosure, the electronic device improves a chip startup rate and a functional safety specification in a low-power mode based on the self-test process with the pre-loaded self-test information, meeting fast startup requirements of the SOC in the low-power mode.

In some embodiments, after step S1400 of in response to an update of a value of the register, the self-test control unit sends the first test instruction to the first processor, so as to trigger, based on the first test instruction, the first processor to enter the self-test mode, the method further includes the following steps.

Step S1500: The self-test control unit obtains the self-test result of the first processor.

Step S1600: The second processor polls the self-test control unit for the self-test result.

Step S1700: After determining, based on the self-test result, that self-test of the first processor is completed, the second processor enables the first processor to enter an operating mode from the self-test mode.

Step S1800: The second processor clears the self-test information in the tightly-coupled memory.

It should be noted herein that for specific implementations of steps S1500 to S1800, refer to steps S400 to S700 in the foregoing embodiments, and details are not described in the embodiments of the present disclosure.

According to the technical solutions shown in the present disclosure, the electronic device implements the dynamic loading of the self-test information based on phased use of the tightly-coupled memory by the second processor, so as to ensure that the first processor can perform self-test in both the warm reset scenario and the sleep wake-up scenario, and improve the startup speed of the first processor. Moreover, the electronic device may also clear the resources in the tightly-coupled memory based on the second processor after the first processor completes the self-test, thereby ensuring that the chip has good operating performance during operation.

The solutions involved in the present disclosure are not limited to the embodiments described above.

### Exemplary apparatus

The chip self-test method provided in the embodiments of the present disclosure is described above. It may be understood that to implement functions of the chip self-test method, a chip self-test apparatus may include corresponding hardware and software for implementing functions of the hardware.

A person skilled in the art should easily conceive that, in combination with the steps of the chip self-test method described in the embodiments of the present disclosure, the embodiments of the present disclosure can be implemented in a form of hardware, in a form of software-driven hardware, or in a form of a combination of software and hardware. Whether a certain function is implemented in a form of hardware or software-driven hardware depends on specific application and design constraints of the technical solutions. A person skilled in the art may use different methods to implement the described functions for each specific application, but such implementation should not be considered beyond the scope of the present disclosure.

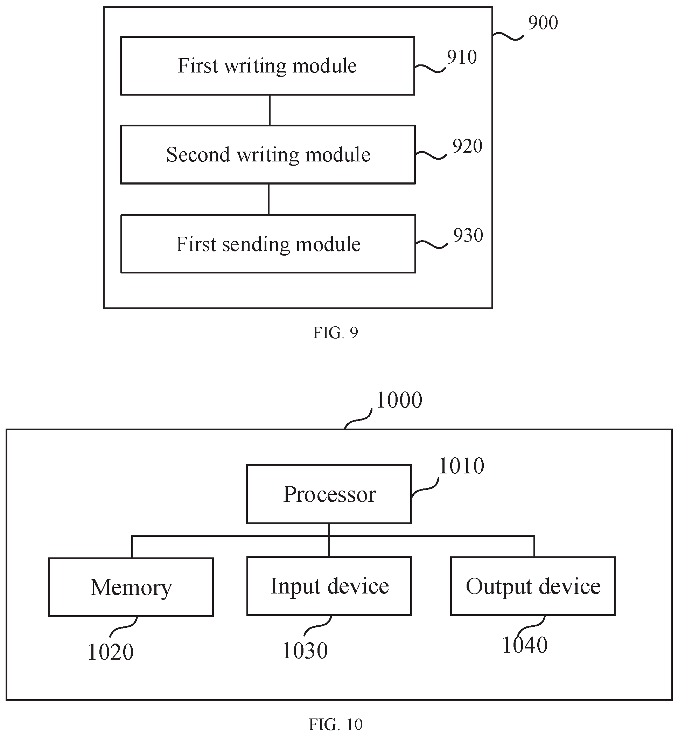

FIG. 9 is a schematic diagram of a structure of a chip self-test apparatus according to an exemplary embodiment of the present disclosure.

As shown in FIG. 9, in an embodiment, a chip self-test apparatus 900 includes:
a first writing module 910, configured to write self-test information from a non-volatile memory into a tightly-coupled memory;
a second writing module 920, configured to write the self-test information from the tightly-coupled memory into a register of a self-test control unit; and
a first sending module 930, configured to, in response to the register of the self-test control unit being updated with the self-test information, send, by the self-test control unit, a first test instruction to a first processor to be self-tested, so as to trigger, based on the first test instruction, the first processor to enter a self-test mode.

According to the chip self-test apparatus provided in the foregoing embodiment of the present disclosure, the self-test information is written from the non-volatile memory into the tightly-coupled memory, and is written from the tightly-coupled memory into the register of the self-test control unit; and in response to the register of the self-test control unit being updated with the self-test information, the first test instruction is sent by the self-test control unit to the first processor to be self-tested, so as to trigger, based on the first test instruction, the first processor to enter the self-test mode. In this way, an electronic device implements dynamic loading of the self-test information based on the tightly-coupled memory in a chip, thereby increasing a chip self-test speed and ensuring fast startup of the electronic device.

In an implementation, an integrated circuit further includes a second processor, and the first writing module 910 is further configured to: in response to startup of the second processor, write, by the second processor, the self-test information from the non-volatile memory into the tightly-coupled memory.

In an implementation, the non-volatile memory includes a flash memory, and the first writing module 910 is further configured to: in response to the startup of the second processor, write, by the second processor based on a direct memory access controller, the self-test information from the flash memory into the tightly-coupled memory.

In an implementation, the apparatus further includes:
a first obtaining module, configured to control the self-test control unit to obtain a self-test result of the first processor;
a polling module, configured to control the second processor to poll the self-test control unit for the self-test result;
a first determining module, configured to control the second processor to enable, after determining, based on the self-test result, that self-test of the first processor is completed, the first processor to enter an operating mode from the self-test mode; and
a first clearing module, configured to control the second processor to clear the self-test information in a random access memory.

In an implementation, the first determining module is further configured to control the second processor to send a release-reset signal to the first processor after the second processor determines, based on the self-test result, that the self-test of the first processor is completed, wherein the release-reset signal is used to control the first processor to exit the self-test mode.

In an implementation, the apparatus further includes a first mode switching module, configured to control the first processor to exit the self-test mode and enter the operating mode in response to the release-reset signal.

In an implementation, the apparatus further includes:
a second sending module, configured to control the second processor to send a reset signal to the first processor, wherein the reset signal is used to control the first processor to enter a sleep mode;
a second mode switching module, configured to control the first processor to enter the sleep mode in response to the reset signal;
a second clearing module, configured to control the second processor to clear resources in the random access memory; and
a loading module, configured to control the second processor to pre-load the self-test information into the random access memory.

In an implementation, the apparatus further includes:
a parsing module, configured to control the second processor to receive wake-up source information, and parse the wake-up source information to obtain a parsing result corresponding to the wake-up source information, wherein the wake-up source information includes at least one of an interrupt signal sent by the first processor, a sensor signal sent by a sensor, a safety message sent by the first processor, a remote safety instruction sent by a server, and a self-test signal sent by a timer;
a third writing module, configured to, in a case where the second processor determines, based on the parsing result, that the first processor needs to be woken up, control the second processor to write the self-test information from the random access memory into the register of the self-test control unit; and
a third sending module, configured to control the self-test control unit to send the first test instruction to the first processor in response to an update of a value of the register, so as to trigger, based on the first test instruction, the first processor to perform self-test.

For beneficial technical effects corresponding to the exemplary embodiment of this apparatus, refer to the corresponding beneficial technical effects of the exemplary method section described above, which are not repeated herein.

### Exemplary electronic device

FIG. 10 is a diagram of a structure of an electronic device according to an embodiment of the present disclosure.

As shown in FIG. 10, an electronic device 1000 includes at least one processor 1010 and a memory 1020.

The processor 1010 may be a central processing unit (CPU) or another form of processing unit having a data processing capability and/or an instruction execution capability, and may control another component in the electronic device 1000 to perform a desired function.

The memory 1020 may include one or more computer program products, which may include various forms of computer readable storage media, such as a volatile memory and/or a non-volatile memory. The volatile memory may include, for example, a random access memory and/or a cache. The non-volatile memory may include, for example, a read-only memory (ROM), a hard disk, or a flash memory. One or more computer program instructions may be stored on the computer readable storage medium. The processor 1010 may run the one or more computer program instructions to implement the chip self-test method according to various embodiments of the present disclosure that are described above and/or other desired functions.

In an example, the electronic device 1000 may further include an input device 1030 and an output device 1040. These components are interconnected through a bus system and/or other forms of connection mechanisms (not shown).

The input device 1030 may further include, for example, a keyboard or a mouse.

The output device 1040 may output various information to the outside, and may include, for example, a display, a speaker, a printer, a communication network, and a remote output device connected to the communication network.

Certainly, for simplicity, FIG. 10 shows only some of the components in the electronic device 1000 that are related to the present disclosure, and components such as a bus and an input/output interface are omitted. In addition, according to specific applications, the electronic device 1000 may also include any other appropriate components.

### Exemplary computer program product and computer readable storage medium

In addition to the foregoing method and device, embodiments of the present disclosure may also provide a computer program product including computer program instructions that, when run by a processor, cause the processor to perform the steps of the chip self-test method according to the embodiments of the present disclosure, that are described in the "Exemplary method" section described above.

The computer program product may be program code, written with one or any combination of a plurality of programming languages, that is configured to perform the operations in the embodiments of the present disclosure. The programming languages include an object-oriented programming language such as Java or C++, and further include a conventional procedural programming language such as a "C" language or a similar programming language. The program code may be entirely or partially executed on a user computing device, executed as an independent software package, partially executed on the user computing device and partially executed on a remote computing device, or entirely executed on the remote computing device or a server.

In addition, the embodiments of the present disclosure may further relate to a computer readable storage medium, on which computer program instructions are stored. The computer program instructions, when run by the processor, cause the processor to perform the steps of the chip self-test method according to the embodiments of the present disclosure, that are described in the "Exemplary method" section described above.

The computer readable storage medium may be one readable medium or any combination of a plurality of readable media. The readable medium may be a readable signal medium or a readable storage medium. The readable storage medium includes, for example but is not limited to electrical, magnetic, optical, electromagnetic, infrared, or semiconductor systems, apparatuses, or devices, or any combination of the above. More specific examples (a non-exhaustive list) of the readable storage medium include: an electrical connection with one or more conducting wires, a portable disk, a hard disk, a random access memory (RAM), a read-only memory (ROM), an erasable programmable read-only memory (EPROM or a flash memory), an optical fiber, a portable compact disc read-only memory (CD-ROM), an optical storage device, a magnetic storage device, or any suitable combination of the above.

Basic principles of the present disclosure are described above in combination with specific embodiments. However, advantages, superiorities, and effects mentioned in the present disclosure are merely examples rather than limitations, and it cannot be considered that these advantages, superiorities, and effects are necessary for the embodiments of the present disclosure. In addition, the specific details disclosed above are merely for examples and for ease of understanding, rather than for limitations. The details described above do not limit the present disclosure to necessarily adopting the foregoing specific details for implementation.

A person skilled in the art may make various modifications and variations to the present disclosure without departing from the spirit and the scope of this application. In this way, if these modifications and variations of this application fall within the scope of the claims and equivalent technologies of the claims of the present disclosure, the present disclosure also intends to include these modifications and variations.

## Claims

1. A chip self-test method, applied to an integrated circuit, wherein the integrated circuit comprises a first processor, and the method comprises:
writing (S100) self-test information from a non-volatile memory into a tightly-coupled memory;
writing (S200) the self-test information from the tightly-coupled memory into a register of a self-test control unit; and
in response to the register of the self-test control unit being updated with the self-test information, sending (S300), by the self-test control unit, a first test instruction to the first processor to be self-tested, so as to trigger, based on the first test instruction, the first processor to enter a self-test mode.

2. The method according to claim 1, wherein the integrated circuit further comprises a second processor, and the writing (S100) self-test information from a non-volatile memory into a tightly-coupled memory comprises:
in response to startup of the second processor, writing (S110), by the second processor, the self-test information from the non-volatile memory into the tightly-coupled memory.

3. The method according to claim 2, wherein the non-volatile memory comprises a flash memory, and the in response to startup of the second processor, writing (S110), by the second processor, the self-test information from the non-volatile memory into the tightly-coupled memory comprises:
in response to the startup of the second processor, writing (S111), by the second processor based on a direct memory access controller, the self-test information from the flash memory into the tightly-coupled memory.

4. The method according to claim 1, wherein after the in response to the register of the self-test control unit being updated with the self-test information, sending (S300), by the self-test control unit, a first test instruction to the first processor to be self-tested, so as to trigger, based on the first test instruction, the first processor to enter a self-test mode, the method further comprises:
obtaining (S400), by the self-test control unit, a self-test result of the first processor;
polling (S500), by the second processor, the self-test control unit for the self-test result;
after the second processor determines, based on the self-test result, that self-test of the first processor is completed, enabling (S600) the first processor to enter an operating mode from the self-test mode; and
clearing (S700), by the second processor, the self-test information in the tightly-coupled memory.

5. The method according to claim 4, wherein the after the second processor determines, based on the self-test result, that self-test of the first processor is completed, enabling (S600) the first processor to enter an operating mode from the self-test mode comprises:
after the second processor determines, based on the self-test result, that the self-test of the first processor is completed, sending (S610), by the second processor, a release-reset signal to the first processor, wherein the release-reset signal is used to control the first processor to exit the self-test mode; and
in response to the release-reset signal, exiting (S620), by the first processor, the self-test mode and entering the operating mode.

6. The method according to claim 1, further comprising:
sending (S800), by the second processor, a reset signal to the first processor, wherein the reset signal is used to control the first processor to enter a sleep mode;
in response to the reset signal, entering (S900), by the first processor, the sleep mode;
clearing (S1000), by the second processor, resources in the tightly-coupled memory; and
pre-loading (S1100), by the second processor, the self-test information into the tightly-coupled memory.

7. The method according to claim 6, further comprising:
receiving (S1200), by the second processor, wake-up source information, and parsing the wake-up source information to obtain a parsing result corresponding to the wake-up source information, wherein the wake-up source information comprises at least one of an interrupt signal sent by the first processor, a sensor signal sent by a sensor, a safety message sent by the first processor, a remote safety instruction sent by a server, and a self-test signal sent by a timer;
in a case where the second processor determines, based on the parsing result, that the first processor needs to be woken up, writing (S1300), by the second processor, the self-test information from the tightly-coupled memory into the register of the self-test control unit; and
in response to an update of a value of the register, sending (S1400), by the self-test control unit, the first test instruction to the first processor, so as to trigger, based on the first test instruction, the first processor to enter the self-test mode.

8. A chip self-test apparatus, applied to an integrated circuit, wherein the integrated circuit comprises a first processor, and the apparatus comprises:
a first writing module (910), configured to write self-test information from a non-volatile memory into a tightly-coupled memory;
a second writing module (920), configured to write the self-test information from the tightly-coupled memory into a register of a self-test control unit; and
a first sending module (930), configured to, in response to the register of the self-test control unit being updated with the self-test information, send, by the self-test control unit, a first test instruction to the first processor to be self-tested, so as to trigger, based on the first test instruction, the first processor to enter a self-test mode.

9. The chip self-test apparatus according to claim 8, wherein the integrated circuit further comprises a second processor, and the first writing module (910) is further configured to:
in response to startup of the second processor, write, by the second processor, the self-test information from the non-volatile memory into the tightly-coupled memory.

10. The chip self-test apparatus according to claim 9, wherein the non-volatile memory comprises a flash memory, and the first writing module (910) is further configured to:
in response to the startup of the second processor, write, by the second processor based on a direct memory access controller, the self-test information from the flash memory into the tightly-coupled memory.

11. The chip self-test apparatus according to claim 8, wherein the apparatus further comprises:
a first obtaining module, configured to control the self-test control unit to obtain a self-test result of the first processor;
a polling module, configured to control the second processor to poll the self-test control unit for the self-test result;
a first determining module, configured to control the second processor to enable, after determining, based on the self-test result, that self-test of the first processor is completed, the first processor to enter an operating mode from the self-test mode; and
a first clearing module, configured to control the second processor to clear the self-test information in a random access memory.

12. The chip self-test apparatus according to claim 11, wherein the first determining module is further configured to control the second processor to send a release-reset signal to the first processor after the second processor determines, based on the self-test result, that the self-test of the first processor is completed, wherein the release-reset signal is used to control the first processor to exit the self-test mode.

13. The chip self-test apparatus according to claim 11, wherein the apparatus further comprises a first mode switching module, configured to control the first processor to exit the self-test mode and enter the operating mode in response to the release-reset signal.

14. A computer readable storage medium, wherein the storage medium stores a computer program, and the computer program is executed by a processor to implement the chip self-test method according to any one of claims 1 to 7.

15. An electronic device, comprising:
a processor; and
a memory, configured to store instructions executable by the processor, wherein
the processor is configured to read the executable instructions from the memory, and execute the instructions to implement the chip self-test method according to any one of claims 1 to 7.
